# EUROPÄISCHE PATENTANMELDUNG

(11) **EP 2 571 117 A1**
(43) Veröffentlichungstag der Anmeldung: **20.03.2013**
(21) Anmeldenummer: 11401593.6
(22) Anmeldetag: 15.09.2011
(51) Int. Cl.: H01S 5/00, H01S 5/026, H01S 5/183

(54) **Lasereinheit mit unterdrückter Rückkopplung**

(71) Anmelder: Axetris AG, 6056 Kägiswil (CH)
(72) Erfinder: Wittmann, Andreas, CH-6074 Giswil (CH); Studer, Michel, CH-6006 Luzern (CH); Protasio, Rui, 6005 Luzern (CH); Fraschina, Corrado, 6030 Ebikon (CH)
(74) Vertreter: Klocke, Peter

(57) **Zusammenfassung**

Lasereinheit 1, bevorzugt für die Gasdetektion, mit einem Halbleiterlaserchip 2 und optional mit einem den von dem Halbleiterlaserchip 2 ausgehenden Laserstrahl 9 formenden Strahlformungselement 4, die vorzugsweise in einem hermetisch abgedichteten Gehäuse mit Austrittsfenster für den Laserstrahl 9 eingeschlossen sind. Erfindungsgemäß ist ein Self-mixing reduzierendes optisches Element 3 an die Austrittszone 10 des Halbleiterlaserchips 2 mit direktem physischem Kontakt angeordnet und mit dem Laserchip zumindest in einer Austrittszone 10 für den Laserstrahl 9 durch ein optisches Medium oder stoffschlüssig verbunden. In einer alternativen Ausführungsform kann der Auskoppelspiegel 6 zunächst auf das Self-mixing reduzierende optische Element 3 aufgebracht werden und dann in einem nachfolgenden Schritt mit einem VCSEL-Halblaserchip, vorzugsweise durch Waferbonden, verbunden werden. Optional ist auf dem Self-mixing reduzierenden optischen Element 3 ein Strahlformungselement 4, beispielsweise eine Mikrolinse angeordnet, die mit dem Self-mixing reduzierenden optischen Element 3 durch ein optisches Medium bzw. stoffschlüssig verbunden ist. Vorzugsweise weisen das Strahlformungselement 4 und das Self-mixing reduzierende optische Element 3 einen identischen Brechungsindex auf und sind mit den Haftmitteln 5, 8 miteinander und mit dem Halbleiterlaserchip 2 verbunden, die eine mit diesen übereinstimmende Brechzahl aufweisen.

## Beschreibung

Die Erfindung betrifft eine Lasereinheit mit einem Halbleiterlaserchip, der einen Auskoppelspiegel mit einer Austrittszone für einen Laserstrahl aufweist, die vorwiegend für die Gasdetektion gedacht ist, jedoch auch in anderen Anwendungsbereichen, beispielsweise in der Telekommunikation, eingesetzt werden kann, und die Rückreflexionen des Laserlichtes in die Austrittszone des Lasers reduziert bzw. unterdrückt.

Im Bereich Sicherheit, Komfort und Umweltschutz besteht für eine Vielzahl von Aufgaben ein großer Bedarf an kostengünstigen, zuverlässigen und hoch empfindlichen Gassensoren. Bekannte Gassensoren weisen Gase häufig mittels Absorptionsspektroskopie nach. Bei dieser Technik wird beispielsweise ein Laserstrahl einer geeigneten Frequenz durch ein Gas oder Gasgemisch geleitet, das das Laserlicht zumindest teilweise absorbiert. Die Frequenz ist abhängig von dem zu detektierenden Gas und so gewählt, dass das Laserlicht mit den Gasatomen bzw. Gasmolekülen möglichst stark wechselwirkt. Der Absorptionsgrad des Laserstrahls wird dabei als Indikator für die Gaskonzentration des jeweiligen Gases genutzt. Für die Gasdetektion eignen sich insbesondere spektral einmodig strahlende Laser.

Bei der Laserabsorptionsspektroskopie wird der von der Laserdiode ausgestrahlte Laserstrahl nach dem Durchtritt durch ein Gas oder Gasgemisch mittels eines licht- oder wärmeempfindlichen Detektorelementes erfasst und das empfangene Signal einem Signalanalysator zur Auswertung zugeleitet. Der Signalanalysator trennt konstante Interferenzmuster von dem empfangenen Signal ab. Er kann jedoch sich ändernde Interferenzmuster, die mehr oder weniger immer auftreten, aus dem empfangenen Signal nicht vollständig eliminieren, womit die Nachweisempfindlichkeit für das zu detektierende Gas aufgrund des verstärkten Rauschens deutlich sinkt.

Sich ändernde Interferenzmuster werden zum einen durch auf den Halbleiterlaseraufbau einwirkende Temperatureinflüsse verursacht, die die Länge des optischen Pfades des Laserlichtes bis zu dem Detektorelement verändern. Des Weiteren können Reflexionen des Laserlichtes an Innenflächen des Gehäuses des Halbleiterlaseraufbaus oder an Grenzflächen von in dem Gehäuse angeordneten strahlformenden oder strahllenkenden optischen Elementen, wie beispielsweise Linsen oder Spiegeln, oder an der Innen- oder Außenfläche des Austrittsfensters für den Laserstrahl derartige Interferenzmuster herbeiführen. Diese Interferenzmuster sind in der Regel ebenfalls temperaturabhängig, indem sich die optische Weglänge für den Laserstrahl in dem Gehäuse temperaturbedingt verändert. Dabei beeinflussen insbesondere Rückreflexionen des Laserlichtes in die Laserapertur des Halbleiterlaserchips den von dem Halbleiterlaserchip ausgesandten Laserstrahl im Hinblick auf das Rauschen äußerst negativ.

Es ist allgemein bekannt, den Halbleiterlaserchip eines Halbleiterlaseraufbaus auf einen zwischen dem Gehäuse und dem Halbleiterlaserchip angeordneten, als aktive Temperatursenke vorgesehenen Peltierelementes anzuordnen, um die Temperatureinflüsse und damit das Auftreten von Interferenzmustern zu begrenzen. Es ist weiterhin aus dem Stand der Technik bekannt, ein den Laserstrahl beeinflussendes Optikelement mit dem Halbleiterlaserchip wärmeleitend zu verbinden, damit das Optikelement gegenüber dem Halbleiterlaserchip einen definierten Temperaturzustand aufweist. Der definierte Temperaturzustand gegenüber dem temperierten Halbleiterlaserchip führt zu einer stabilen optischen Weglänge des Laserstrahls zwischen dem Halbleiterlaserchip und dem Strahlformungselement.

Diese Art der thermischen Kopplung ist beispielsweise aus der EP 2 320 215 A1 bekannt. Diese Offenlegungsschrift offenbart einen Halbleiterlaseraufbau, insbesondere zur Gasdetektion, mit einem Gehäuse mit elektrischen Anschlüssen, das einen Boden und vorzugsweise ein Austrittsfenster aufweist. In dem Gehäuse sind ein Halbleiterlaserchip und eine Temperiereinrichtung für den Halbleiterlaserchip angeordnet. Die Temperiereinrichtung ist von einem Peltierelement gebildet, das mit seiner unteren Flachseite mit dem Boden des Gehäuses und mit seiner oberen Flachseite mit dem Halbleiterlaserchip verbunden ist. Zwischen dem Halbleiterlaserchip und dem Austrittsfenster des Gehäuses ist ein temperiertes Strahlformungselement, beispielsweise eine kollimierende Mikrolinse angeordnet. Dabei steht das Strahlformungselement mit dem Halbleiterlaserchip in innigem physischen Kontakt und ist vorzugsweise mit einer Grenzfläche mit der Laserapertur stoffschlüssig oder adhäsiv verbunden. Damit weist das Strahlformungselement gegenüber dem Halbleiterlaserchip auch einen definierten Temperaturzustand auf.

Der vorstehend beschriebene bekannte Halbleiterlaseraufbau, bei dem das Strahlformungselement in direktem physischem Kontakt mit der Laserapertur steht, lässt jedoch störende Rückreflexionen des Laserlichtes in die Laserapertur des Halbleiterlaserchips ohne Beeinflussung ungehindert zu.

Um Rückreflexionen zu reduzieren bieten sich optische Isolatoren an, die jedoch in der Regel sehr gross im Vergleich zur Dimension des Halbleiterlasers sind und deshalb in einem kompakten optischen Sensor sehr viel Platz beanspruchen. Zudem erlaubt der relativ hohe Preis eines solchen, meist aus mehreren optischen Elementen bestehenden Systems es nicht, solch ein System in ein kostengünstiges Detektionssystem einzubauen.

Alternativ zu optischen Isolatoren bietet sich an, ein optisches Element einzusetzen, das nur die Polariationsrichtung des rückreflektierten Lichtes dreht. Beispielhaft wird auf die Druckschriften WO 01/02838 A1 und EP 0 729 565 B1 verwiesen. Allerdings bringt das Einbringen eines solchen optischen Elementes als diskretes Element, auch wenn es eine Antireflexbeschichtung (Entspiegelung) aufweist, durch die zusätzlichen optischen Grenzflächen nicht wirklich Vorteile. Die selbst bei hochwertigen Entspiegelungen an diesen Grenzflächen auftretenden Rückreflexionen führen im Strahlengang selbst zu optischen Interferenzen. Damit reduziert sich der Vorteil der Polarisationsdrehung stark und kann unter Umständen sogar zu mehr optischem Rauschen führen. Dies und die zusätzlichen Kosten für eine Entspiegelung führten in der Vergangenheit dazu, dass derartige Lösungen für die Gasabsorption nicht in Betracht gezogen wurden.

Ausgehend von dem vorstehend beschriebenen Stand der Technik liegt der Erfindung die Aufgabe zugrunde, eine Möglichkeit vorzuschlagen, mit der Interferenzerscheinungen des Laserstrahls deutlich weiter reduziert werden.

Diese Aufgabe wird erfindungsgemäß durch eine Lasereinheit für die Gasdetektion mit den Merkmalen des Anspruchs 1 gelöst. Weitere vorteilhafte Ausgestaltungen sind den rückbezogenen Ansprüchen zu entnehmen.

Der Erfindung liegt die Idee zugrunde, einer starken Wechselwirkung des von außen über die Austrittszone in den optischen Resonator des Halbleiterlaserchips rückreflektierten Laserlichtes mit dem zu emittierenden Laserlicht vorzubeugen. Dazu wird auf die Polarisationsrichtung des rückreflektierten Laserlichtes Einfluss genommen. Ziel ist es, die Polarisationsebene der Rückreflexion derart zu ändern, d.h. zu drehen, dass sich diese in einem möglichst großen Winkel, idealerweise orthogonal zu der Polarisationsebene des emittierten Laserstrahls erstreckt. Kerngedanke der Erfindung ist, ein optisches Element mit den oben beschriebenen Eigenschaften derart einzubringen, dass zusätzliche Grenzflächen im Strahlengang vermieden werden. Somit ist eine Modulation des ausgehenden Laserstrahls durch die Rückreflexionen deutlich reduziert.

Bei der erfindungsgemäßen Lasereinheit ist an der Austrittszone des Auskoppelspiegels des Halbleiterlaserchips ein optisches Element angeordnet, das die Empfindlichkeit der Lasereinheit für Self-mixing Effekte reduziert. Das Self-mixing reduzierende optische Element ist für Laserlicht weitgehend lichtdurchlässig und überdeckt den Auskoppelspiegel mindestens im Bereich der Austrittszone. Dabei sind das Self-mixing reduzierende optische Element und der Auskoppelspiegel zumindest an der Austrittszone vollflächig miteinander verbunden. Hierbei können sich auf dem Auskoppelspiegel noch eine Metallschicht bzw. weitere Schichten befinden, die im Bereich der Austrittszone eine Öffnung für die Lichtemission haben.

In einer bevorzugten Ausführungsform der Erfindung ist das Self-mixing reduzierende optische Element mit dem Halbleiterlaserchip über eine optisches Medium oder stoffschlüssig verbunden. Das Self-mixing reduzierende optische Element ist dadurch auch in direktem Kontakt mit dem Halbleiterlaserchip, so dass auch eine thermische Kopplung besteht, die einen Temperaturausgleich ermöglicht.

Dieses optische Element kann ganz allgemein als optischer Isolator ausgebildet sein. Es genügt aber auch, dass das Self-mixing reduzierende Element nur Einfluss auf die Polarisationsrichtung nimmt. In diesem Fall weist es optisch aktives Material auf, das derart strukturiert ist, dass es die Schwingungsebene eines passierenden Lichtstrahls (Laserstrahls) dreht. Die Stärke der Drehung der Schwingungsebene ist abhängig von der Wellenlänge des einfallenden Lichtes und auch abhängig von der Ausrichtung des Self-mixing reduzierenden optischen Elementes gegenüber dem Lichtstrahl. Einige Kristalle drehen das Licht, was von der Asymmetrie der Kristallstruktur herrührt. Es können aber auch transparente Materialien verwendet werden, die selbst nicht optisch aktiv sind, indem beispielsweise ein Magnetfeld mit Hinblick auf den Faraday Effekt oder ein elektrisches Feld, beispielsweise an eine Flüssigkristallzelle, angelegt und so die Polarisationsrichtung des Lichtstrahls gedreht wird. Bevorzugt ist ein solches Self-mixing reduzierendes optisches Element als ebenes flaches Plättchen ausgebildet und weist spezielle von der Struktur des Materials abhängige Achsen auf, zu denen die Polarisation der elektromagnetischen Strahlung des Laserstrahls in einem bestimmten Winkel anzuordnen ist, um eine optimale Wirkung zu erzielen.

Das Self-mixing reduzierende optische Element, welches von dem von der Laserapertur ausgehenden Laserstrahl und von den Rückreflexionen des Laserstrahls in entgegengesetzter Richtung durchquert wird, verändert die Polarisationsrichtung des rückreflektierenden Laserstrahls gegenüber dem emittierten Laserstrahl deutlich und mindert daher die Modulation des von dem Halbleiterlaserchip erzeugten Laserlichtes. Die Modulation ist bei übereinstimmenden Polarisationsebenen der entgegengesetzt läufigen Laserstrahlen am größten und bei orthogonal zueinander ausgerichteten Polarisationsebenen am kleinsten. Vorzugsweise wird bei der erfindungsgemäßen Lasereinheit ein Verzögerungsplättchen, beispielsweise ein Quarzglasplättchen, als Self-mixing reduzierendes optisches Element eingesetzt. Ein solches Quarzglasplättchen, weist eine durch die Kristallisation des Quarzes in einer enantimorphen Struktur bedingte optische Aktivität auf. Die optische Achse wird bevorzugt so angeordnet, dass diese in der Schnittebene des Kristalls liegt.

Bei Verzögerungsplatten, die auch als λ/n-Plättchen oder Wellenplättchen bezeichnet werden, handelt es sich um optische Elemente, die die Polarisation und Phase von durchtretenden elektromagnetischen Wellen wie z. B. Laserlicht, ändern können. Dabei ist n in der Regel eine ganz natürliche Zahl. Ein λ/4-Plättchen beispielsweise verzögert Licht, das parallel zu einer bauteilspezifischen Achse polarisiert ist, um eine Viertel-Wellenlänge gegenüber dazu senkrecht polarisiertem Licht. Es kann bei geeigneter Einstrahlung aus linear polarisiertem Licht zirkular oder elliptisch polarisiertes Licht erzeugen und zirkular polarisiertes Licht wieder in linear polarisiertes Licht umwandeln. Die Polarisationsänderungen kommen dadurch zustande, dass das hindurch geleitete Laserlicht in zwei senkrecht stehende Polarisationsrichtungen zerlegt wird, die die λ/4-Plättchen mit unterschiedlicher Geschwindigkeit passieren, wobei deren Phasen gegeneinander verschoben sind. Ein solches Plättchen besteht typischerweise aus einem doppelbrechenden Kristall mit passend gewählter Dicke und Ausrichtung bzw. einer entsprechend hergestellten Folie.

Beispielsweise erzeugt ein solches λ/4-Plättchen der erfindungsgemäßen Lasereinheit eine Drehung der Polarisation der Laserstrahlung zwischen dem emittierten und dem rückreflektierten Strahl von 90°, so dass die beiden in unterschiedlichen Richtungen fortschreitenden Laserstrahlen nicht innerhalb des Halbleiterlaserchips interferieren. Damit werden Self-mixing Effekte im Halbleiterlaserchip vermieden bzw. stark unterdrückt. Dazu wird das λ/4-Plättchen vorzugsweise derart gegenüber dem Halbleiterlaserchip angeordnet, dass die optische Achse des λ/4-Plättchens einen Winkel von 45° zu der Polarisationsrichtung des linear polarisierten Laserstrahls des Halbleiterlaserchips aufweist. Anstelle eines λ/4-Plättchens kann auch ein Verzögerungsplättchen verwendet werden, dessen Dicke ein ungerades Vielfaches einer Viertel-Wellenlänge des Laserstrahls aufweist.

Bei einer vorteilhaften Variante der erfindungsgemäßen Lasereinheit ist der Auskoppelspiegel des Halbleiterlaserchips auf dem Self-mixing reduzierenden optischen Element aufgebracht. Vorzugsweise wird dabei als Self-mixing reduzierendes optisches Element eine dünne Quarzglasplatte verwendet. Die Spiegelschichten können vorzugsweise aufgedampft oder gesputtert werden (z.B. Siliziumoxid (SiOx) und Titanoxid (TiO2)) oder chemisch mittel PECVD, d.h. durch plasmaunterstützte chemische Gasabscheidung aufgebracht werden, wobei diese Schichten beispielsweise amorphes Silizium oder Siliziumdioxid aufweisen. Die separat von einer VCSEL-Halblaserstruktur gefertigte Einheit Self-mixing reduzierendes optisches Element mit Auskoppelspiegel wird vorzugsweise mittels eines an sich bekannten Waferbondverfahrens mit der Halblaserstruktur verbunden, wobei der Auskoppelspiegel in Richtung der Halblaserstruktur weist. Ein zur Herstellung eines herkömmlichen, d.h. ohne Self-mixing reduzierenden optischen Elements ausgebildeten VCSEL-Halbleiterlaserchip geeignetes Waferbondverfahren wird beispielsweise in der Patentschrift EP 1 378 039B1 offenbart.

Bei dem bekannten Verfahren wird eine untere und eine obere Substratlage mit einer mittleren Wellenleiterlage durch Waferbonden stoffschlüssig verbunden. Die drei Lagen sind dabei mehrschichtig ausgebildet. Die obere und die untere Substratlage umfassen jeweils ein Galium-Arsenit-Substrat (GaAs-Substrat) und eine Spiegelschicht, die aus mehreren epitaktisch hergestellten Halbleiterschichten besteht. Die Wellenleiterlage ist in üblicher Weise aufgebaut. Nachdem die beiden Substratlagen mit der Wellenleiterlage stoffschlüssig verbunden sind, wird an der oberen Substratlage, d.h. auf der zur Auskopplung des Laserstrahls vorgesehenen Flachseite des Halbleiterlaserchips das nach außen weisende GaAs-Substrat entfernt, so dass die erhalten gebliebene Spiegelschicht als Auskoppelspiegel für den Laserstrahl wirken kann. Die untere Substratlage bleibt unverändert, wobei die in den Halbleiterlaserchip eingebettete, dem Auskoppelspiegel zugewandte Spiegelschicht den rückwärtigen Laserspiegel bildet.

Der für die erfindungsgemäße Lasereinheit in einer bevorzugten Ausführungsform verwendete wafergebondete Halbleiterlaserchip mit Self-mixing reduzierendem Element, wird in ähnlicher Weise hergestellt. Jedoch wird anstelle der oberen Substratlage die einstückig hergestellte Einheit als Self-mixing reduzierendes optisches Element mit dielektrisch hergestelltem Auskoppelspiegel verwendet. Da das Self-mixing reduzierende optische Element für Laserlicht durchlässig ist, kann der Auskoppelspiegel ohne weitere Maßnahmen wirken. Der aus dem Auskoppelspiegel austretende Laserstrahl passiert problemlos das Self-mixing reduzierende optische Element.

In einer Ausführung der erfindungsgemässen Lasereinheit mit separat hergestelltem Halbleiterlaserchip und Self-mixing reduzierendem optischen Element ist das Self-mixing reduzierende optische Element vorzugsweise an dem Auskoppelspiegel mit einem optischen Medium verbunden, das einen dem Self-mixing reduzierenden optischen Element ähnlichen oder entsprechenden Brechungsindex aufweist. Das optische Medium bildet eine dünne und homogene Schicht zwischen dem Halbleiterlaserchip und dem Self-mixing reduzierenden optischen Element. Bei dem optischen Medium handelt es sich dabei um ein Material, das für das Laserlicht nur geringfügig absorbierend ist. Das optische Medium kann beispielsweise eine Klebstoffschicht, eine Gelschicht oder eine Flüssigkeitsschicht sein. Zudem kann das Self-mixing reduzierende optische Element leicht verkippt zu dem Auskoppelspiegel angeordnet werden, um Fabry Perot Kavitäten, die zu Interferenzen führen können, zu vermeiden.

Beim Übertritt des emittierten Laserstrahls von dem Auskoppelspiegel zu dem optischen Medium werden die Lichtwellen des Laserstrahls gemäß dem Brechungsgesetz gebrochen. Indem ein optisches Medium verwendet wird, dessen Brechzahl idealerweise identisch mit der Brechzahl des Verzögerungsplättchens ist, entfällt eine mögliche Reflexionsfläche für das Laserlicht an dem Self-mixing reduzierenden optischen Element. Der Laserstrahl passiert das optische Medium, ohne dass die Laserlichtwellen beim Übergang zu dem Self-mixing reduzierenden optischen Element nochmals ihre Richtung ändern.

Bei einer Ausführungsform kann das Self-mixing reduzierende Element direkt bei der Herstellung des Halbleiterlaserchips mit dem Chip verbunden, d.h. in den Chip integriert werden. Die Verbindung erfolgt vorzugsweise durch Waferbonden. Waferbonden ist ein aus der Halbleiter- und Mikrosystemtechnik bekanntes Verfahren, bei dem beispielsweise zwei Scheiben aus Silizium, Quarz oder dergleichen ohne zusätzliches Adhäsionsmittel miteinander verbunden werden. In einer bevorzugten Ausführungsform der erfindungsgemäßen Lasereinheit ist dabei das Self-mixing reduzierende optische Element an einer VCSEL-Laserstruktur befestigt.

Bei einer anderen bevorzugten Ausführungsform der erfindungsgemäßen Lasereinheit trägt das Self-mixing reduzierende optische Element an der Austrittszone für den Laserstrahl ein optisches Strahlformungselement, wobei das Strahlformungselement indirekt mit dem Halbleiterlaserchip verbunden ist. Das Strahlformungselement ist vorzugsweise mit dem Self-mixing reduzierenden optischen Element durch ein optisches Medium bzw. stoffschlüssig verbunden. Es kann beliebiger Art sein. Bevorzugt wird eine kollimierende Mikrolinse, vorzugsweise eine Kugellinse oder Halbkugellinse, auf dem Self-mixing reduzierenden optischen Element angeordnet.

Vorzugsweise ist das Strahlformungselement an dem Self-mixing reduzierenden optischen Element mit einem optischen Medium befestigt, das einen dem Strahlformungselement oder dem Self-mixing reduzierenden optischen Element ähnlichen oder entsprechenden Brechungsindex aufweist. Das optische Medium bildet eine dünne homogene Schicht, die auf einer Seite eben und auf der anderen Seite gewölbt und damit an die Form des Strahlformungselements angepasst ist.

Das optische Medium, das das Self-mixing reduzierenden optischen Element mit dem Strahlformungselement bzw. mir dem Halbleiterlaserchip verbindet, kann beispielsweise einen Klebstoff, ein Gel oder eine Flüssigkeit aufweisen. Beim Übertritt des Laserstrahls von dem Self-mixing reduzierenden optischen Element zu dem Strahlformungselement wird, bedingt durch den angepassten Brechungsindex des optischen Mediums, der Laserstrahl an den Grenzflächen der Haftmittelschicht nur noch ein einziges Mal gebrochen.

Bei einer Variante der erfindungsgemäßen Lasereinheit ist das Self-mixing reduzierende optische Element an dem Auskoppelspiegel mit einem ersten optischen Medium und das Strahlformungselement an dem Self-mixing reduzierenden optischen Element mit einem zweiten optischen Medium befestigt, die einen Brechungsindex aufweisen, der mit dem Brechungsindex des Strahlformungselementes und des Self-mixing reduzierenden optischen Elementes übereinstimmt. Durch den einheitlichen Brechungsindex des optischen Mediums, des Self-mixing reduzierenden optischen Elementes und des Strahlformungselements wird das Verbundsystem Halbleiterlaserchip, erste Haftmittelschicht, Self-mixing reduzierendes optisches Element, zweite Haftmittelschicht und Strahlformungselement auf eine einzige lichtbrechende Grenzfläche zwischen diesen reduziert. Die wirksame Grenzfläche ist zwischen dem Auskoppelspiegel und dem ersten optische Medium angeordnet. Damit entfallen mögliche Reflexionsflächen für das Laserlicht an dem Self-mixing reduzierenden optischen Element und dem Strahlformungselement.

Die Vorteile, die durch das dem jeweiligen Brechungsindex angepasste optische Medium zwischen der Laserapertur und dem Self-mixing reduzierenden optischen Element bzw. zwischen dem Self-mixing reduzierenden optischen Element und dem Strahlformungselement für den emittierten Laserstrahl erreicht werden, treffen auch auf die Rückreflexionen des emittierten Laserstrahls zu.

Das optische Medium kann auch eine dünne Ölschicht sein, wobei die Brechungsindices von Öl und Self-mixing reduzierendem optischen Element auf einander abgestimmt sind.

Die Dicke des jeweiligen optische Mediums ist bevorzugt sehr dünn zu wählen. Sie soll weniger als 100 pm betragen, damit eventuell entstehende Fabry Perot Kavitäten zu relativ kleinen niederfrequenten Etalons führen, die das Messsignal einer die erfindungsgemäße Lasereinheit als Sender aufweisenden Gasdetektionsvorrichtung nicht stören, da sie nur als Background wahrgenommen werden.

Zudem begünstigt eine relativ dünne Schichtdicke des Self-mixing reduzierenden Elementes, von beispielsweise weniger als 200 µm, bzw. deren relativ kleine Masse, eine sehr gute thermische Ankopplung des Strahlformungselementes an die Temperatur des Laserchips.

Bevorzugt wird eine Ausführungsform der Erfindung, bei der der Halbleiterlaserchip in einem Gehäuse mit Austrittsöffnung für den Laserstrahl angeordnet, vorzugsweise in einem hermetisch abgedichteten Gehäuse mit Austrittsfenster eingeschlossen ist.

Mittels der erfindungsgemäßen Lasereinheit können Interferenzerscheinungen des von dem Halbleiterlaserchip erzeugten Laserstrahls deutlich reduziert werden. Durch das die Polarisationsrichtung von Rückreflexionen des Laserstrahls räumlich drehende Self-mixing reduzierende optische Element wird die Wechselwirkung des in die Laserapertur rückreflektierten Laserlichtes mit dem zu emittierenden Laserlicht minimiert. Zudem wird durch die Befestigung des Self-mixing reduzierenden Elementes an der Laserapertur und optional der Befestigung des Strahlformungselementes an dem Self-mixing reduzierenden Element mit einem optische Medium mit gleichem Brechungsindex die Zahl der der Laserapertur zugewandten Reflexionsflächen in dem Strahlengang des Laserstrahls auf ein Minimum beschränkt. Des Weiteren werden damit das Self-mixing reduzierende optische Element und das Strahlformungselement thermisch mit dem Halbleiterlaserchip gekoppelt, um die Temperatureinflüsse auf die optische Weglänge in dem Gehäuse der Lasereinheit zu reduzieren. Als Laserquelle können oberflächenemittierende Quellen (sog. VCSEL) aber auch Kantenemitter eingesetzt werden. Da auf die Entspiegelung des Self-mixing reduzierenden Elementes verzichtet werden kann, muss für ein quarzbasiertes Verzögerungsplättchen nur wenig investiert werden, womit es möglich wird, ein sehr kostengünstiges Lasermodul mit geringer Baugröße herzustellen.

Nachfolgend wird die Erfindung anhand dreier in der Zeichnung dargestellten Ausführungsbeispiele näher erläutert. Weitere Merkmale der Erfindung können sich aus der folgenden Beschreibung des Ausführungsbeispiels der Erfindung in Verbindung mit den Ansprüchen und der beigefügten Zeichnung ergeben. Die einzelnen Merkmale können für sich allein oder zu mehreren bei unterschiedlichen Ausführungsformen der Erfindung verwirklicht sein. Es zeigen:
- Figur 1: eine erfindungsgemäße Lasereinheit mit einem mit dem Halbleiterlaserchip durch ein optisches Medium oder stoffschlüssig verbundenen Self-mixing reduzierenden optischen Element;
- Figur 2: die Lasereinheit aus Figur 1 mit einem durch ein optisches Medium oder stoffschlüssig verbundenen Strahlformungselement; und
- Figur 3: einen wafergebondeten Halbleiterlaserchip mit Self-mixing reduzierendem optischen Element.

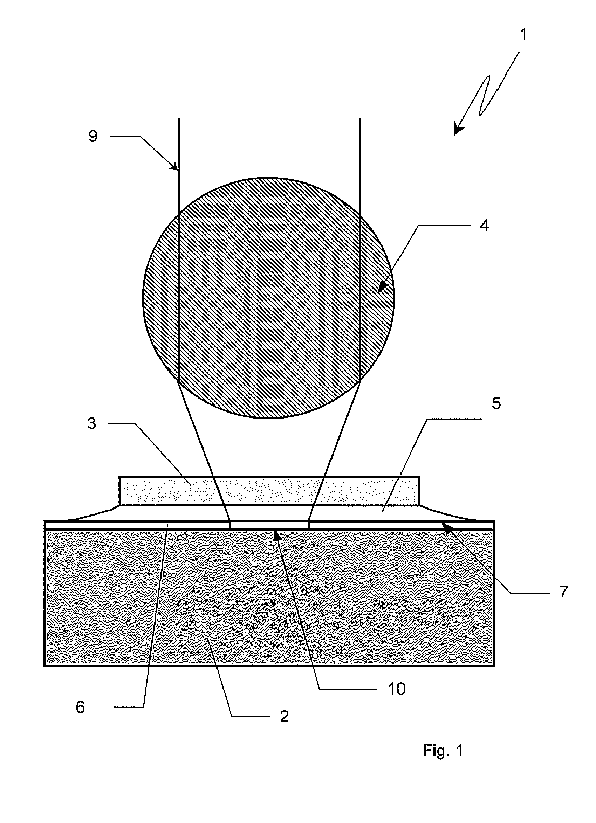

Die Figur 1 zeigt eine Lasereinheit 1, vorzugsweise zur Anwendung bei der Gasdetektion, mit einem in der Zeichnung nicht dargestellten hermetisch abgedichteten Gehäuse mit Austrittsfenster für den Laserstrahl, in dem ein Halbleiterlaserchip 2 angeordnet ist. Der Halbleiterlaserchip 2 trägt ein λ/4-Plättchen 3 im Bereich einer Austrittszone 10 für einen Laserstrahl 9, das mittels einer Haftmittelschicht 5 als optisches Medium aus Klebstoff mit einem Auskoppelspiegel 6 des Halbleiterlaserchips 2 verbunden ist. Das λ/4-Plättchen 3 ist plan ausgebildet, ebenso wie die Haftmittelschicht 5, mit der das λ/4-Plättchen 3 an der die aufweisende Austrittszone 10 Flachseite 7 des Halbleiterlaserchips 2 fixiert ist. Die Haftmittelschicht 5 erstreckt sich über die gesamte Austrittszone 10. Die Haftmittelschicht 5, die den Auskoppelspiegel 6 und das Self-mixing reduzierende optische Element 3 miteinander verbindet, besitzt einen mit dem Self-mixing reduzierenden optischen Element 3 übereinstimmenden Brechungsindex. Mit Abstand zu dem λ/4-Plättchen 3 ist eine optionale Mikrolinse 4 angeordnet, die an einer in der Zeichnung nicht abgebildeten Halterung befestigt ist, die von dem Gehäuse der Lasereinheit ausgeht.

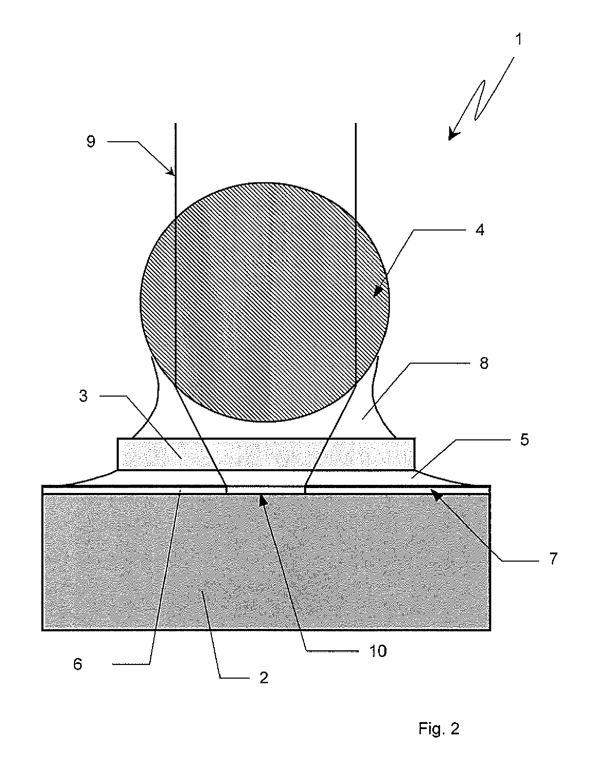

Die Figur 2 zeigt eine Variante des in der Figur 1 abgebildeten Ausführungsbeispiels, mit einer auf dem Self-mixing reduzierenden optischen Element 3 angeordneten Mikrolinse 4, die als Kugellinse ausgebildet ist. Zwischen dem λ/4-Plättchen 3 und der Mikrolinse 4 erstreckt sich eine zweite Haftmittelschicht 8, die die Mikrolinse 4 und das λ/4-Plättchen 3 miteinander verbindet. Die zweite Haftmittelschicht 8 ist auf der dem λ/4-Plättchen 3 zugeordneten Seite eben und auf der der Mikrolinse 4 gegenüberliegenden Seite nach innen gewölbt ausgebildet. Der Meniskus der zweiten Haftmittelschicht 8 ist entsprechend dem Radius der Mikrolinse 4 geformt. Die erste zwischen dem Halbleiterlaserchip 2 und dem Self-mixing reduzierenden optischen Element angeordnete Haftmittelschicht 5 und die zweite Haftmittelschicht 8, die gegenüber dem λ/4-Plättchen 3 vorzugsweise eine geringere Stärke aufweisen, besitzen einen Brechungsindex, der dem des Materials des λ/4-Plättchens 3 und der Mikrolinse 4 weitgehend entspricht. Ein von dem Auskoppelspiegel 6 an der Austrittszone 10 ausgehender divergierender Laserstrahl 9 erstreckt sich ohne Richtungsänderung bis in die Mikrolinse 4. Die Mikrolinse 4 kollimiert den Laserstrahl 9 nach der zweiten Haftmittelschicht 8.

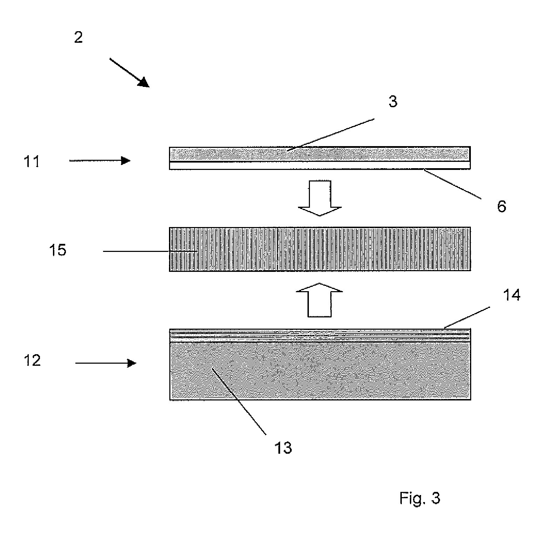

Die Figur 3 zeigt den Aufbau eines wafergebondeten Halbleiterlaserchips 2 mit Self-mixing reduzierendem optischen Element 3. Dargestellt ist der Halbleiterlaserchip 2 vor dem Waferbonden. Durch das Waferbonden wird eine obere Substratlage 11 von oben und eine untere Substratlage 12 von unten mit einer Wellenleiterlage 15 verbunden. Die obere Substratlage 11 umfasst das Self-mixing reduzierende optische Element 3 mit dem Auskoppelspiegel 6. Die untere Substratlage 12 weist ein unteres GaAs-Substrat 13 und einen darauf angeordneten rückwärtigen Laserspiegel 14 auf. Die Darstellung ist nicht maßstabgetreu.

## Patentansprüche

1. Lasereinheit (1), vorzugsweise für die Gasdetektion, mit einem Halbleiterlaserchip (2), der einen Auskoppelspiegel mit einer Austrittzone (10) für einen Laserstrahl (9) aufweist, **dadurch gekennzeichnet, dass** ein Self-mixing reduzierendes optisches Element (3) an der Austrittszone (10) angeordnet ist, wobei das Self-mixing reduzierende optische Element (3) und der Laserchip zumindest an der Austrittszone (10) vollflächig miteinander verbunden sind.

2. Lasereinheit nach Anspruch 1, **dadurch gekennzeichnet, dass** das Self-mixing reduzierende optische Element (3) mit dem Laserchip mittels eines optischen Mediums oder stoffschlüssig verbunden ist.

3. Lasereinheit nach Anspruch 1 oder 2, **dadurch gekennzeichnet, dass** das Self-mixing reduzierende optische Element (3) als optischer Isolator ausgestaltet ist.

4. Lasereinheit nach Anspruch 1 oder 2, **dadurch gekennzeichnet, dass** das Self-mixing reduzierende optische Element (3) ein Verzögerungsplättchen, vorzugsweise ein Quarzplättchen, ist und eine Dicke aufweist, die eine Verzögerung entsprechend einem einfachen oder ungeraden Vielfachen einer Viertel-Wellenlänge des Laserstrahls (9) erzeugt.

5. Lasereinheit nach einem der vorstehenden Ansprüche, **dadurch gekennzeichnet, dass** der Auskoppelspiegel (6) auf das Self-mixing reduzierende optische Element (3) aufgebracht als eine Einheit an den Laserchip, der als eine VCSEL-Halblaserstruktur ausgebildet ist, durch Waferbonden befestigt ist.

6. Lasereinheit nach einem der vorstehenden Ansprüche 1 - 4, **dadurch gekennzeichnet, dass** das Self-mixing reduzierende optische Element (3) durch Waferbonden an einer VCSEL-Laserstruktur befestigt ist.

7. Lasereinheit nach einem der vorstehenden Ansprüche, **dadurch gekennzeichnet, dass** auf dem Self-mixing reduzierenden optischen Element (3) **ein** optisches Strahlformungselement (4), vorzugsweise eine als Mikrolinse ausgebildete Kugel- oder Halbkugellinse angeordnet ist.

8. Lasereinheit nach Anspruch 7, **dadurch gekennzeichnet, dass** das Self-mixing reduzierende optische Element (3) mit dem Strahlformungselement (4) mittels eines optischen Mediums oder stoffschlüssig verbunden ist.

9. Lasereinheit nach Anspruch 2 und/oder 8, **dadurch gekennzeichnet, dass** das optische Medium (5) zwischen dem Self-mixing reduzierenden optischen Element (3) und dem Halbleiterlaserchip (2) einen dem Self-mixing reduzierenden Element (3) ähnlichen oder entsprechenden Brechungsindex bzw. zwischen dem Self-mixing reduzierenden optischen Element (3) und dem Strahlformungselement (4) einen dem Self-mixing reduzierenden Element (3) oder dem Strahlformungselement (4) ähnlichen oder entsprechenden Brechungsindex aufweist.

10. Lasereinheit nach Anspruch 9, **dadurch gekennzeichnet, dass** das optische Medium (5) ein Klebstoff, ein Gel und/oder eine Flüssigkeit ist.

11. Lasereinheit nach einem der vorangegangenen Ansprüche, **dadurch gekennzeichnet, dass** der Halbleiterlaserchip (2) in einem Gehäuse mit Austrittsöffnung für den Laserstrahl (9), vorzugsweise in einem hermetisch abgedichteten Gehäuse mit Austrittsfenster, eingeschlossen ist.
